# EUROPEAN PATENT APPLICATION

(11) **EP 3 040 779 A1**
(43) Date of publication of application: **06.07.2016**
(21) Application number: 14200630.3
(22) Date of filing: 30.12.2014
(51) Int. Cl.: G03F 9/00

(54) **A maskless exposure apparatus with alignment**

(71) Applicant: VISITECH AS, 3003 Drammen (NO)
(72) Inventor: Jørgensen, Trond, N-3018 Drammen (NO); Kirkhorn, Endre, N-3031 Drammen (NO); Tafjord, Øyvind, N-3150 Tolvsrød (NO)
(74) Representative: Onsagers AS

(57) **Abstract**

A maskless exposure apparatus comprises a light source (302) providing an exposure beam (306); a light modulator (302) modulating the exposure beam (306)according to an exposure pattern;an exposure optical system (303, 304, 308) delivering the modulated exposure beam as an image (311) provided by the light modulator onto a substrate (307); and a measurement system (303, 304, 305, 308, 309) configured to measure a position of an alignment mark previously patterned on the substrate. The exposure optical system and the measurement system have at least partially concurrent optical paths.

## Description

In lithography machines such as PCB lithography direct imaging exposure machines, computer generated artwork (CAD) files are exposed on PCB panels. It is important to place the artwork correctly on the PCB panel for several reasons:
- The artwork must not be exposed outside the PCB panel
- The artwork must be placed correctly on multilayer PCB panels to ensure that there are correct electrical connection between the layers

The physical PCB panel to be exposed by the lithography machine may suffer from unlinearities and deformations due to different processes performed on the PCB panel such as lamination, copper etching etc prior to the exposure. Hence the artwork to be exposed on the physical panel needs to be adjusted to fit to the physical panel.

Various lithography machines, e.g. PCB lithography direct imaging printers, are utilizing e. g. CCD, CMOS or similar cameras for capturing positions of several fiducial marks on a PCB panel layer (outer- , inner layer). This process is known in the lithography industry as registration. These fiducial marks, e.g. patterns, marks, drilled holes or similar, are defined to be placed on different and dedicated positions having given coordinates on the PCB panel. The lithography machine gathers these multiple fiducial mark coordinates on a PCB panel and compares these measured fiducial mark coordinates with the corresponding fiducial mark coordinates defined in the corresponding artwork (CAD) file stored in the machine. Hence, the set of measured (observed) fiducial marks captured from the registration cameras can be compared with the corresponding set of fiducial mark coordinates from the artwork (CAD) file in order to calculate rotation, scaling and warping of the artwork (CAD) file to be exposed on the panel, prior to the exposure. Multiple algorithms and recipes to make the artwork (CAD) file fit to the physical panel exist on the market.

The registration cameras are placed within the machine in such way that they can capture the fiducial marks. The registration camera(s) are placed outside the electronic light projector(s) or exposure unit, e.g. laser scanning beam, in the lithography machine.

As the positions and coordinates of the registration cameras within the machine are known, the captured fiducial mark coordinates can be calculated.

Correspondingly, as the position and the coordinates of the exposure unit (electronic light projector or e.g. laser scanning unit) within the machine are known, the projected image pattern position can be calculated.

Based on this information, the artwork can be exposed on the correct position on the PCB panel.

However, as the registration camera and the exposure unit are physically split into two different units in the machine, the relative position between these units may vary due to environmental parameters such as temperature and humidity variations, and because of mechanical forces initiated on the exposure unit and registration camera during machine operation (e.g. acceleration of devices during motion)

As the accuracy requirement for lithography machines are in the µm range, any relative position variation between the exposure unit and the registration camera can create too large tolerances on the exposed image on the PCB panel. Hence, there will be a need for extensive control of the environmental parameters and the forces initiated on the exposure unit and the registration camera. Frequent position calibration will be required for the devices, which is time consuming and will cause the machine to be out of operation during this calibration.

This issue can be solved in different ways. One solution is to mount the registration cameras directly on the exposure unit exterior in order to minimize the position offset between the external registration camera assembly and the exposure unit assembly caused by environmental and physical influences. However, if there is any additional exposure image position offset caused by the exposure unit interior such as optomechanical tolerances as e.g. projection lens and prism mounting unit due to environmental parameter changes, this cannot be calibrated by mounting the registration camera on the exposure unit exterior. The solution described in this patent will be able to also handle any exposure image offsets due to exposure unit interior tolerances.

US2003/0211409 describes a projection photolithograpy technique using a laser scanner where the main projection imaging optics is used to create a fluorescence mark for aligning a mask and a substrate. In this device, the alignment mark is exposed on a different mask than the lithographic mask, due to the need of a fluorescent material. In order to use the main projection imaging optics for the alignment marks, there is arranged a dichroic mirror in the light path. The use of such mirrors may cause distortions of the image to be exposed, thus leading to less accurate lithographic exposure.

The object of the invention is to provide a maskless exposure apparatus which meets the above mentioned challenges.

The object of the invention is achieved by means of the features of the patent claims.

In one embodiment a maskless exposure apparatus, comprises a light source providing an exposure beam; a light modulator modulating the exposure beam according to an exposure pattern; an exposure optical system delivering the modulated exposure beam as an image provided by the light modulator onto a substrate; and a measurement system configured to measure a position of an alignment (fiducial) mark, object or another item, such as e.g. drill hole, previously patterned on the substrate, wherein the exposure optical system and the measurement system have at least partially concurrent optical paths.

The exposure beam light source may for example be an UV light source. The measurement system may for example use a beam of visible light, or any other convenient wavelength of the light.

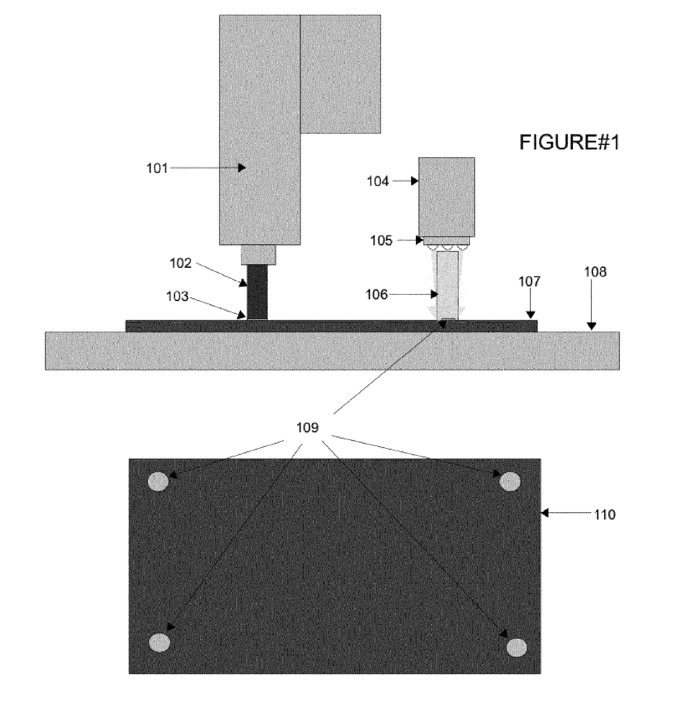

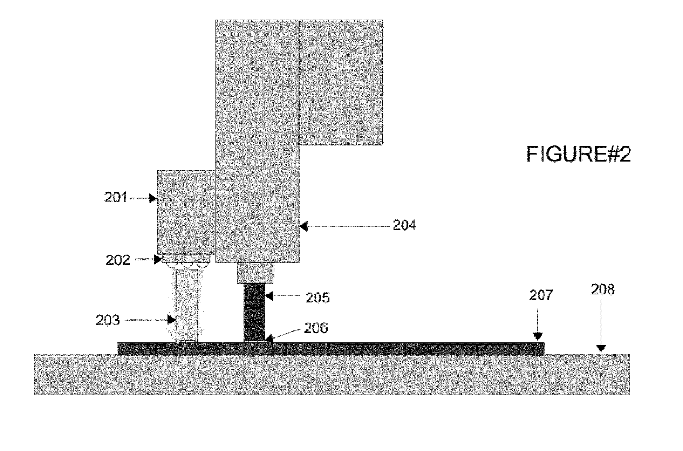

The invention according to the claims facilitates a camera as a part of the measurement system, to be placed with its picture path within the optical path of the exposure unit. The camera shares the same optics (such as dichroic beamsplitter prism and projection lens, etc.) as the exposure unit. This will eliminate the need for the external registration camera of prior art. This camera will share the optomechanical structure (optical parts mounting units) with the electronic light source modulator. The electronic light source modulator is for example an electronic light projector based on DMD technology or similar. Any variation in position for the exposed image provided by the exposure unit caused by both exposure interior (optomechanics such as optical part mounting units) and exterior (exposure unit framework and chassis mechanics) will also be applied to the position of the registration camera as the same mechanics and optical path is shared for both exposure unit and registration camera. Thus, the requirement for frequent calibration of the relative position offsets of the exposure unit and the registration camera as shown in FIGURE 1 and FIGURE 2 is not required.

The invention will now be described in more detail, by reference to the accompanying figures.
Figure 1 and Figure 2 illustrates prior art techniques for an exposure unit and registration camera.
Figure 3 shows an embodiment of a maskless exposure apparatus with integrated camera according to the invention.
Figure 4 illustrates the optical path of the registration camera of the embodiment in figure 3.

Figure 1 describes an electronic light projector 101 according to prior art, creating a projected light beam 102 on to the UV sensitive media 107 placed on a table 108 as a projected light pattern 103. The electronic camera device 104 with light source 105 captures the fiducial objects 109 from the reflected light beam 106.

Figure 2 describes another prior art electronic camera device 201 with a light source 202 for the camera mounted directly on the electronic light projector 204 to minimize the position offset between the external registration camera assembly and the exposure unit assembly caused by environmental and physical influences. The reflected lightbeam 203 from the UV sensitive media 207 will create a pattern on the camera when a fiducial mark is detected. The electronic light projector is providing a light beam 205 creating an exposure pattern 206 on to the UV sensitive media 207 laying on a table 208. The disadvantages of the light projectors in figures 1 and 2 was discussed earlier in this document.

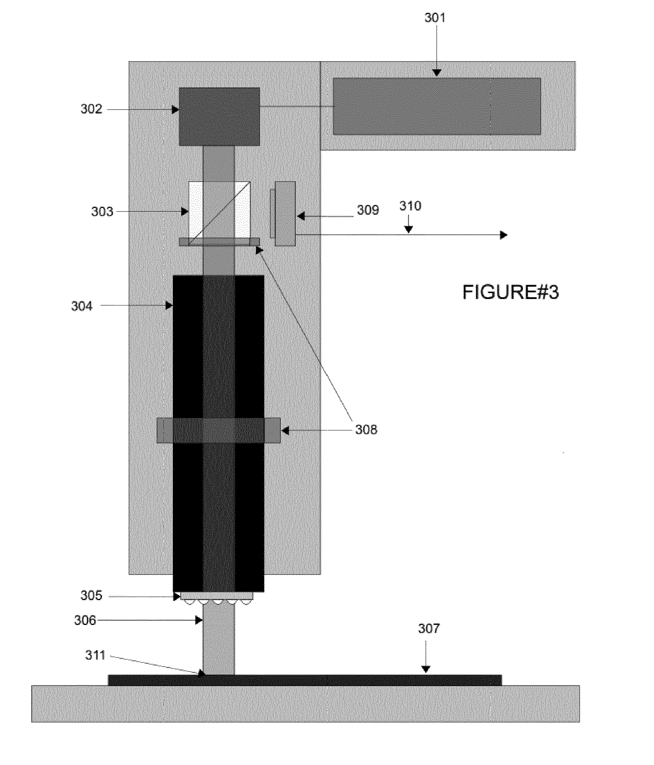

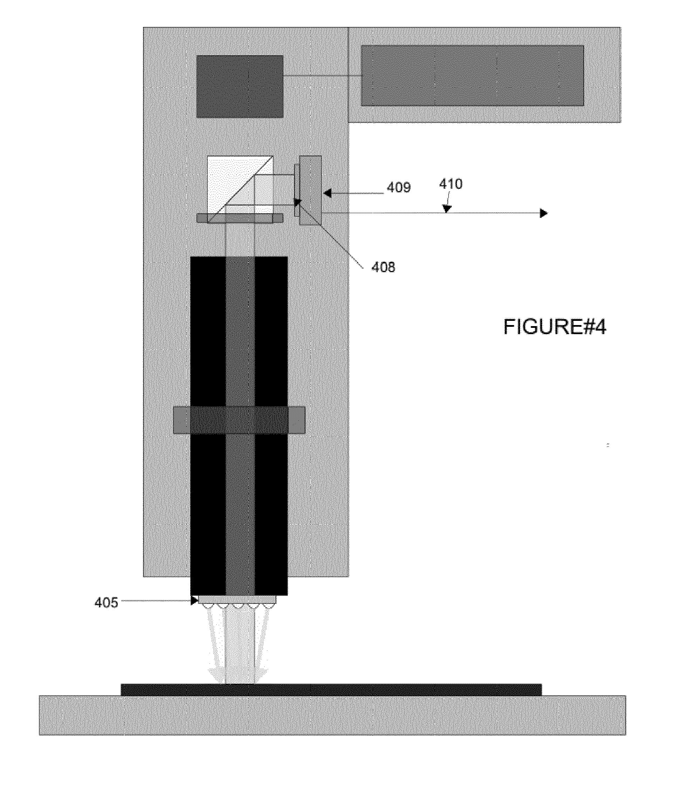

Figure 3 and 4 shows an embodiment of a maskless exposure apparatus which comprises a light source 302 providing an exposure beam 306, a light modulator 301, 302 modulating the exposure beam 306 according to an exposure pattern, and an exposure optical system 303, 304, 308 delivering the modulated exposure beam as an image 311 provided by the light modulator onto a substrate 307. A measurement system 303, 304, 305, 308, 309 is incorporated in the exposure apparatus and is configured to measure a position of an alignment (fiducial) mark previously patterned on the substrate. The exposure optical system and the measurement system have at least partially concurrent optical paths.

Figure 3 and Figure 4 illustrates separately the optical paths of the exposure beam and the measurement beam respectively. Together this thus forms an electronic light projector with built-in registration camera module 309, as a part of the measurement system. An electronic light modulator controller 301 provides control signals and data to an electronic light source and modulator 302. The modulated light beam 306 passes through the dichroic beam splitter prism 303 and the projection lens 304 before it enters the UV sensitive media/substrate 307. The optical parts mounting units 308, the projection lens 304 and the dichroic beam splitter prism 303 are common for both the projected light beam 306 and the reflected light beam 408 (see figure 4) captured by the built-in CCD camera 409. Hence, any variation in position for the exposed image 311 caused by tolerances in the light modulator and light source 302, optomechanical parts, such as 308 and optics 303, 304 will also be applied to the position of the registration camera, which will minimize the need for regularly calibration of the camera module versus the electronic light projector. The CCD camera will require additional light provided by a light source 405. The CCD camera is connected to a PC through a standard interface (Ethernet, USB or similar) for further image processing .

The integrated camera in the exposure unit will reduce the need for a potential second motion system for the registration camera(s) in the machine as described in FIGURE 1 as the exposure unit will always have a motion system for relative motion towards the panel to be exposed. The invention can therefore reduce number of parts and cost of a system.

## Claims

1. A maskless exposure apparatus, comprising:
a light source (302) providing an exposure beam (306);
a light modulator (302) modulating the exposure beam (306)according to an exposure pattern;
an exposure optical system (303, 304, 308) delivering the modulated exposure beam as an image (311) provided by the light modulator onto a substrate (307); and
a measurement system (303, 304, 305, 308, 309) configured to measure a position of an alignment mark previously patterned on the substrate, wherein the exposure optical system and the measurement system have at least partially concurrent optical paths.

2. A maskless exposure apparatus according to claim 1, further comprising:
a stage configured to receive a substrate on a moving table thereof and move the substrate in X- and Y- directions.

3. A maskless exposure apparatus according to claim 1, the measurement system comprising a light source (305), a beam splitter (303), projection optics (304) and a camera (309).

4. A maskless exposure apparatus according to claim 3, where the light source is a source of visible light and the light source of the exposure beam is a UV light source.

5. A maskless exposure apparatus according to claim 3 or 4, where the measurement system comprises a dichroic mirror, splitting the light projected provided by the light modulator (302) on to the media and the visible light reflected on to the CCD camera (409) from the media when the light source (405) is enabled

6. A maskless exposure apparatus according to claim 3, where the measurement system comprises a beamsplitter prism.

7. A maskless exposure apparatus according to claim 1, further comprising a control unit for controlling the light modulator (302) and the movement of the moving table, based on feed back from the measurement system.

8. A maskless exposure apparatus according to claim 1, where the alignment mark, is a fiducial mark, an object or another item, such as e.g. drill hole.
